(19) Europäisches Patentamt
European Patent Office
Office européen des brevets

(11) Publication number: **0 284 313**
**A1**

(12) **EUROPEAN PATENT APPLICATION**

(21) Application number: **88302423.4**

(22) Date of filing: **18.03.88**

(51) Int. Cl.[4]: **B05D 1/36**, H01L 29/28, H01L 49/02, C08J 5/12

(30) Priority: **25.03.87 FI 871319**

(43) Date of publication of application: **28.09.88 Bulletin 88/39**

(84) Designated Contracting States: **AT BE CH DE ES FR GB GR IT LI LU NL SE**

(71) Applicant: **K & V LICENCING OY**
**Höyläämötie 11**
**SF-00380 Helsinki(FI)**

(72) Inventor: **Kinnunen, Paavo**
**Punarinnantie 4**
**SF-02660 Espoo(FI)**
Inventor: **Virtanen, Jorma**
**Ristiaallonkatu 4 C 71**
**SF-02320 Espoo(FI)**

(74) Representative: **Newell, William Joseph et al**
**D. Young & Co., 10 Staple Inn**
**London WC1V 7RD(GB)**

(54) **Method for the preparation of a monomolecular film with a symmetrical molecular distribution pattern and use of such a film.**

(57) The invention concerns a method for the preparation of a monomolecular film exhibiting a symmetrical distribution pattern of the molecules. For the preparation of the film a mixture is used comprising on the one hand a compound (I) of liquid crystal type having a hydrophilic part and a lipophilic part, the lipophilic part comprising two or three substantially aliphatic long-chained hydrocarbon chains, and on the other hand a compound (II) of liquid crystal type, which is of the same type as that defined above, but wherein one of the hydrocarbon chains contains covalently bound a group which sterically differs from the hydrocarbon chain. The molar fraction (x) of the compound (II) in the mixture of compounds (I) and (II) used for the preparation of the film is

$$x = \frac{2}{P - f + 2}$$

wherein f refers to the number of side chains in the compound (II) and $P = a_o^2 + a_ob_o + b_o^2$, wherein $a_o$ and $b_o$ are either zero or positive integers and $a_o + b_o \neq$ zero, and indicate the coordinates of a sterically differing group in 60° coordinate system having its main directions in the film plane and its origo at a side chain containing a sterically differing group. The films obtained may, depending on the nature of the covalently bound sterically differing group, be used in different application in electronics, for example as computer memory elements.

EP 0 284 313 A1

# Method for the preparation of a monomolecular film with a symmetrical molecular distribution pattern and use of such a film

The present invention concerns a method for the preparation of a monomolecular film of Langmuir-Blodgett type exhibiting a symmetrical molecular distribution pattern. The invention also concerns the use of such a film.

According to the invention it is possible, by taking advantage of the inherent organizational tendency of molecules under specific circumstances, to make films containing permanently symmetrically distributed groups exhibiting for example electrical or optical properties. Depending on the nature of these specific groups, the films made may be used for example in such electronic , electrical, electrochemical or photochemical applications wherein the symmetrically distributed active groups and the changes in their energy states caused e.g. by means of external excitation, such as light, may be utilized. As examples there may be mentioned photocells, sensors, indicators, microcircuits and especially computer memories. The structures can be used also in lithographic methods in microelectronics when specific characteristics are desired of the sensitizing compounds.

Lyotropic liquid crystals are for example the long-chained diesters, diamides and diethers of phosphoglycerol derivatives, such as of phosphoglycerol. Thus they exhibit the optical and electrical properties of crystals, but the mechanical properties of liquids. Due to their amphiphilic nature, they orient themselves at the interface between two phases (e.g. gas/water) as a monomolecular layer in such a manner that the fatty chains extend in a parallel fashion in a direction away from the hydrophilic group, e.g. the phosphoric acid group, the main direction of the fatty chains being a direction at right angles to the film plane. Similar liquid crystal properties are exhibited generally by compounds containing two or more long-chained substantially aliphatic hydrocarbon groups.

A method has now been developed by the Applicants for the preparation of a so-called Langmuir-Blodgett film from a compound of liquid crystal type comprising two or three substantially aliphatic long-chained hydrocarbon groups, in which film the degree of symmetry of the fatty chains is high, not only in a direction at right angles to the film plane, but in the lateral direction as well. By including into part of these hydrocarbon chains a sterically differing group, for example a charge transfer and/or a polarizable group, and by using a compound containing such a group at specific molar fractions in the starting mixture used for the preparation of the film, the side chains containing such a group organize or distribute themselves in a symmetrical, i.e. a hexagonal (trigonal) pattern in the film, forming a so called super lattice. This symmetry may be taken advantage of for example by exciting the whole film or only a part thereof externally, such as by using light or a voltage, which causes a highly localized excitation of this group, which, depending on this group, manifests itself for example as a colour change, a charge, or radiation, e.g. fluorescence radiation.

According to this invention, there is provided a method for the preparation of a monomolecular film exhibiting a symmetrical distribution pattern in which a mixture of at least two compounds is used for the preparation of the film, the mixture comprising

a) a compound (I) of liquid crystal type having a hydrophilic part and a lipophilic part, the lipophilic part comprising two or three substantially aliphatic long-chained hydrocarbon groups, and

b) a compound (II) of liquid crystal type, which is of the same type as that defined under a), but wherein one of the hydrocarbon chains contains covalently bound a group which sterically differs from the hydrocarbon chain, whereby the molar fraction (x) of the compound (II) in the mixture of compounds (I) and (II) used for the preparation of the film is

$$x = \frac{2}{P - f + 2}$$

wherein f refers to the number of side chains in the compound (II) and $P = a_o^2 + a_ob_o + b_o^2$, wherein $a_o$ and $b_o$ are either zero or positive integers and $a_o + b_o \neq$ zero, and indicate the coordinates of a sterically differing side chain in a 60° coordinate system having its main directions in the film plane and its origo situated at a side chain containing a sterically differing group.

The nature of the hydrophilic part or group in the compound (I) or (II) is not critical but may be any hydrophilic group suitable for the formation of a film, such as a hydroxy group, a hydroxy-lower alkyl group, an amino or a lower alkyl-mono-or -disubstituted amino group, a carboxy group, a carbamyl group, a

carboxy group esterified with a lower alkyl group, a phosphoryl group, a sulfo group, etc.

The substantially aliphatic long-chained hydrocarbon group means in this context a chain containing approximately 8 to 30, preferably 12 to 20 carbon atoms, and that the group may contain also non-aliphatic groups and heteroatoms (O, S and N) as long as it remains substantially aliphatic to its nature. The aliphatic hydrocarbon group may also contain groups which are capable of polymerization with other side chains, for example double or triple bonds, or may in their end positions contain e.g. photoactivated groups, e.g. diazo groups coupled to a benzene group, which may polymerize with the substrate surface used as a support for the film.

The choice of the sterically differing group naturally depends on the intended use of the finished film. A "sterically differing group" refers to a group which to its threedimensional structure is more voluminous than the part of the hydrocarbon chain that the sterical group substitutes for. Thus the sterically differing group may be a cyclic, either mono-or polycyclic, preferably aromatic, bridged or ring-fused group. Typical representatives are the aromatic groups with 1 to 6 rings, such as phenyl, naphtyl, anthryl, phenanthryl, or more complex aromatic systems, such as pyrene, perylene or triphenylene. These are typical groups participating in charge-transfer. In order to improve the electrical characteristics of the groups, they may contain suitable substituents, such as alkyl (advantageously 1 to 3 C-atoms), alkoxy (advantageously 1 to 3 C-atoms), cyano, hydroxy, oxo, amino, substituted amino, e.g. lower alkylamino, thioether groups, etc.

As sterically differing photochromic groups e.g. the merocyanine, salicylaldoxime groups, azobenzene, cinnamic acid may be mentioned, which are suitable in applications wherein for example light is used as the external stimulus.

As sterically differing heterocyclic groups the polycyclic aromatic groups may be mentioned which are suitable for example in applications wherein sensitizers are required, which subsequent to absorbing a light quantum, transfer it to an acceptor.

As further groups may be mentioned carbazole, quinone, hydroquinone, anthraquinone, TCNQ, tetrathiofulvalens and analogues.

A sterically differing group may also be formed by a polymerizable group, which polymerizes either to the support surface, e.g. a diazo group coupled to a benzene group, or with adjacent side-chains, such as double or triple bonds.

The sterically differing group covalently bound to the side chain may be located at any position in the chain, but for reason of easy manufacture it is preferably in the end position.

A suitable group of compounds for the purposes of the invention is disclosed in co-pending European Patent Application No. 883 filed concurrently herewith, our reference E188/8/WJN. In this compounds are described having the general formula

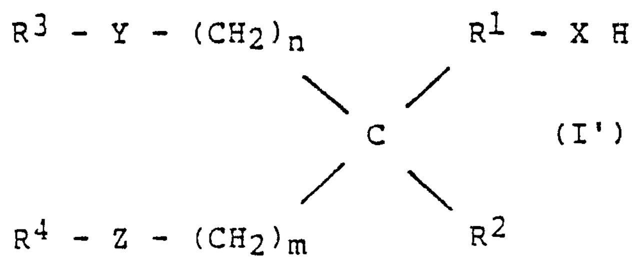

(I')

wherein

$R^3$ and $R^4$ independently are a substantially aliphatic hydrocarbon group containing approximately 8 to 30 carbon atoms, Y and Z are the group -O-, -C(=O)-O-, which over the oxygen atom is bound to the group $-CH_2-$, or they are $-CH_2-$, m and n are zero or one, $R^1$-XH is a polar group in which XH means hydroxy (OH) , carboxyl (COOH), amino ($NH_2$), lower alkyl substituted amino and $R^1$ means a direct bond, a carbonyl group -C(=O)-, lower alkylene, especially methylene, or lower alkylene-carboxyl-lower alkylene, $R^2$ is hydrogen, lower alkyl, or lower alkoxycarbonyl, or may in addition be the same as $R^1$-X-H, or the same as $R^3$ $-Y-(CH_2)_n$.

In our co-pending European Patent Application the preparation of these compounds using per se known methods, has been explained in more detail.

The compound (II) to be used in the method disclosed herein corresponds to the above mentioned formula with the exception that one of the long-chained hydrocarbon groups contains also a sterically differing group.

Also phosphoglycerol and -threitol derivatives, respectively, are suitable for the preparation of the film according to the invention, the derivatives having the formulas (Ia) and (Ib)

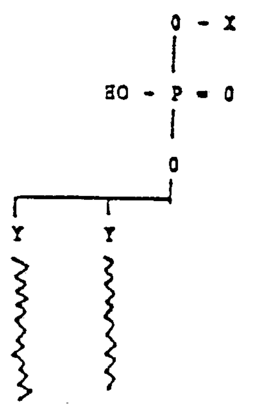

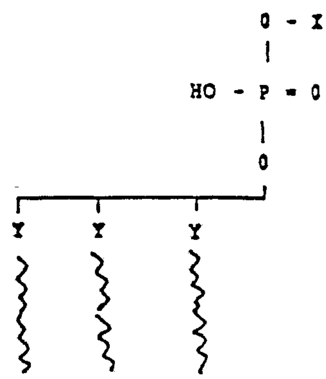

in which formulas Y refers to the group -O-, -C(=O)-O-or -NH-, the zig-zag-symbols ( 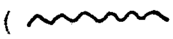 ) mean a substantially aliphatic long-chained hydrocarbon group, and X is hydrogen, or the rest of an alcohol, preferably a lower alkanol, amino-lower alkanol, serine, choline or 1-or 3-glycerol, which forms an ester with the phosphoric acid group.

According to an advantageous mode of the invention, in the mixture together with the compound (I) a compound (II) of the same basic structure is used, one of the side chains thereof, however, containing a sterically differing group.

The compounds to be used for making the film may be prepared in a per se known manner.

In order to attach the hydrophilic group for the preparation of the compound according to the formula (I') easily obtainable polyfunctional starting materials may be used, which are either soluble in organic solvents or are made soluble by means of a suitable protecting group during the synthesis. For example from the diols obtained as intermediates the monoester or -ether may first be prepared by known methods. Correspondingly a second hydrocarbon chain may be attached over an ester or ether bond. Into a malonic acid diester obtained as an intermediate two similar or different, optionally substituted hydrocarbon groups may be added stepwise.

After the removal of the protecting groups the functional groups of the hydrophilic end moiety may be converted to other groups. For example, a carboxylic acid group may be removed by decarboxylation, converted to an amide or reduced with borane to an alcohol.

The glycerol and the threitol derivatives may be prepared for example by introducing into glycerol or D-mannitol, or threitol respectively, the acyl, amide and/or alkyl side chains present in the final product, which optionally contain a sterically differing group (cf M. Kates, Methods in Membrane Biology, vol. 8, 1977, Plenum Publ. Corp. p. 219-290). Thereafter the substituted D-mannitol is split and reduced to the corresponding glycerol. The substituted glycerol may thereafter be esterified in its free position in order to introduce the desired phosphoryl group or its derivative.

A suitable process for the preparation of 1,2-diacyl-sn-glycerols is disclosed in the EP-patent 37 582. Into such a compound a phosphoryl glycerol group may be introduced by reacting 1,2-diacyl-glycerol with phosphoryl chloride in the presence of triethylamine. Thereafter the compound obtained is reacted with 1-trityl-sn-glycerol in the presence of triethylamine and the hydroxy groups in the phosphoryl glycerol are liberated. In the publication Eibl, H., Proc. Natl. Acad. Sci., (1978) p. 40-74 methods are disclosed for the preparation of phosphoryl ethanolamine and -choline.

The threitol derivatives may be prepared by means of methods analogous to those of glycerol.

In our international patent application WO 87/00343 the steps are described which are necessary for example to introduce a charge transfer group into a side chain to be included in a glycerol or threitol frame.

The film according to the invention may be made using Langmuir-Blodgett film-forming technique. This technique is based on allowing a film-forming surface active compound orient itself as a monomolecular layer at the interface between two different phases, for example the interface between a liquid, such as water, glycerol etc, and a gas, such as air, argon etc, the hydrophilic part of the molecule orienting itself towards the liquid and the hydrophobic part, i.e. the lipophilic part, orienting itself in a direction away from the liquid.

In the original publication by Irwin Langmuir (Langmuir, I. (1917) J. Am. Chem. Soc. 39, 1848) the principles are disclosed according to which the organisation of the compounds into a monomolecular surface film takes place. The monograph by George Gaines (Gaines, G.L., Jr (1966) Insoluble Monolayers at Liquid-Gas Interfaces, Interscience Publishers, John Wiley and Sons Inc., New York 1966) deals extensively with different methods for the preparation of and research relating to monomolecular surface

films.

In order to make the film according to the invention a mixture of the compound (I) and the compound (II), wherein the molar proportion of the compound (II) fulfills the afore defined requirement, is dissolved in a suitable or ganic solvent or solvent mixture, for example in chloroform or cyclohexane, and is spread onto the surface of a liquid contained in a trough. By means of a boom which rests on top of the trough and which is in contact with the liquid surface, the available surface area of the liquid-gas-interface is restricted, the total area of the monomolecular surface film thus decreasing or increasing. By means of the boom it is thus possible to regulate the surface tension of the film, which is inversely proportional to the surface pressure of the film, and which is determined by measuring the force exerted on a sensor in the film by means of a sensitive balance. By means of the surface pressure the mutual distance between the side chains may be adjusted in a stepless manner.

From the film spread as a monomolecular layer, for example onto a water surface, the solvent evaporates rapidly. When a support forming the substrate is transported through the interface, preferably at constant speed, the film is deposited as a monomolecular layer onto the substrate, the lipophilic part towards the substrate when the support is transported through the interface in a direction from air to water, and the hydrophilic part towards the substrate when the support is transported through the film in the opposite direction.

By transporting the support several times through the interface, substantially any number of film layers may be deposited onto the substrate.

As the supporting surface any material suitable for this purpose may be used, for example silicon, glass, quartz glass, metal or a suitable plastic. In case the support surface simultaneously serves as an electrode, a conducting material has to be used, such as a metal, or an inert material coated with a conducting layer. The support surface may also be pretreated as has been disclosed in our international patent application WO 86/04063.

It is to be noted that the fatty acids, alcohols, amines and their derivatives as such may be poorly soluble in the solvents used for the preparation of Langmuir-Blodgett films at liquid-gas-interfaces. By including such insoluble fatty compounds in structures such as phospholipids, or for example as three side chains in a threitol compound, the compounds thus obtained are soluble for example in chloroform and may in this form easily be spread as monomoleculars layers at an adjustable surface pressure onto a water surface, which is a prerequisite for the preparation of Langmuir-Blodgett films on solid substrates. The films prepared may also be polymerized either on the surface of the liquid, or after having been transferred to the support, by forming crosslinks between the side chains, using e.g. light or heat. By means of polymerization the the order of symmetry and the distances between the side chains may be stabilized by "freezing". Alternatively the chains may in a suitable manner be attached to the support surface, either as the whole film or only specific parts thereof depending on the desired use. The non-polymerized parts may, if desired, be removed, for example by leaching.

In the following the membrane structure or lattice is considered from a geometrical point of view and the calculations relating thereto are presented, in which membrane both the molecules as well as the hydrocarbon side chains containing the sterically differing groups are arranged hexagonally. In the discussion, the molecules containing a sterically differing group are called guest molecules and the normal molecules are called host molecules.

The mixture containing guest and host molecules thus forms at specific molar proportions a monomolecular film latti ce, a super lattice, wherein the guest molecules are symmetrically distributed and also exhibit a symmetrical order which is identical with the symmetrical order of the host molecules.

In the following reference is made to the drawing, wherein:-Figures 1 and 2 disclose schematically two-dimensional hexagonal film lattices obtained with different molar proportions, viewed from above,

Figure 3 is the fluorescence curve for the product of Example 1, and Figures 4 and 5 are IU curves for the product of Example 2.

In Figures 1 and 2 each white ring denotes one "normal" side-chain, i.e. a host element, and a black ring a side chain containing a sterically differing group, i.e. a guest element. Any position in this lattice may be defined by means of two coordinates (u, v) in a coordinate system, the main axes u and v of which are located in the plane of the film and which form a 60° angle with each other. In the mode of Figure 1, the coordinates for three guest elements are (0,0), (3,1) and (-1,4).

It is assumed that the origin of the coordinate system is located at one of the guest elements. The nearest guest element is given the coordinates $a_o$ and $b_o$. The coordinates $u_g$, $v_g$ for any guest element are obtained using matrix multiplication by combining successively two unit symmetry operations.

(2) $u_g = ka_o - lb_o$

(3) $v_g = la_o + (k + l)b_o$

These equations provide the coordinates for any guest element. On the v-axis $u_g = 0$, and the integer equation is obtained

(4) $0 = ka_o - lb_o$

The parameters k and l can be solved (Stewart B.M., Theory of Numbers, Collier-Macmillan, London. 1968 p. 96) .

(5) $k = b_o i/d$

(6) $l = a_o i/d$ wherein i is any integer and d is a common divisor of $a_o$ and $b_o$.

On the v-axis the coordinates of the guest elements are

(7) $u_g = 0$

(8) $v_g = (a_o^2 + a_o b_o + b_o^2)i/d = (P_t/d)i$

where $P_t = a_o^2 + a_o b_o + b_o^2$

All guest elements on the v-axis are equally spaced and they are separated by a constant distnace of $P_t/d$.

The rows parallel to the v-axis are considered. If $0 < u_g < d$ there are no solutions and consequently such a row does not contain any guest elements. If $u_g = d$ the equation (2) has a solution. Translational symmetry implies that the distribution of the guest elements in this row ($u_g = d$) is identical to the v-axis. The periodicity of the lattice is d rows. Formally the lattice can be seen as being formed by parallelopipeds which consist of d rows. of the length $P_t/d$ and which thus contain $P_t$ elements, one of which is a quest element. There may be two types of rows in the lattice. One contains only host elements and the other may contain in addition also guest elements, separated by $P_t/d - 1$ host elements.

It is assumed that a guest molecule contains f side chains of which one contains a sterically differing group. Thus out of $P_t$ chains, $P_t$ -f belong to the host molecule and f chains to the guest molecule. For one guest molecule there are $(P_t - f)/2$ host molecules. The possible molar proportions $x_t$ of the guest molecule are thus

$$(9) \qquad x_t = \frac{1}{1 + \frac{P_t - f}{2}} = \frac{2}{P_t - f + 2}$$

When using a compound containing 2 side chains, for example phospholipids, wherein f = 2, one obtains

$x_t = 2/P_t$

Correspondingly using a compound containing 3 side chains, for example threitols, wherein f = 3, one obtains

$x_t = 2/(P_t - 1)$

If the guest molecules containing f side chains form aggregates with m molecules, the possible guest molar proportions are obtained from the formula

$$x_t = m \cdot \frac{2}{P_t - m \cdot f + 2}$$

In Figure 2 two different guest element distribution patterns are disclosed. In the case a) the structure is defined by $a_o = 2$ and $b_o = 1$. The common divisor d is 1 and $P_t = 7$. Thus all rows are identical and the repeating unit contains 7 elements.

In the case b) $a_o = 2$ and $b_o = 2$. The commmon divisor d = 2 and $P_t = 12$. Only every other row contains guest elements and these rows contain a repeating unit of 6 elements.

In the following Table the possible molar proportions are disclosed for compounds containing two side chains in a hexagonal lattice when $a_o + b_o \leq 12$.

<u>Table 1</u>

Hexagonal lattice compositions for binary mixtures of a labeled guest molecule and an unlabeled host molecule. The molar proportions $x_t$ of the guest molecule are shown as a function of the coordinates $a_o$ and $b_o$.

| $a_o$ | $b_o$ | $x_t$ |
|---|---|---|
| 1 | 1 | 0.667 |
| 2 | 0 | 0.500 |
| 2 | 1 | 0.286 |
| 3 | 0 | 0.222 |
| 2 | 2 | 0.167 |
| 3 | 1 | 0.154 |
| 4 | 0 | 0.125 |
| 3 | 2 | 0.105 |
| 4 | 1 | 0.095 |
| 5 | 0 | 0.080 |
| 3 | 3 | 0.074 |
| 4 | 2 | 0.071 |
| 5 | 1 | 0.065 |
| 6 | 0 | 0.056 |
| 4 | 3 | 0.054 |
| 5 | 2 | 0.051 |
| 6 | 1 | 0.047 |
| 7 | 0 | 0.041 |
| 7 | 1 | 0.035 |
| 8 | 1 | 0.027 |
| 9 | 1 | 0.022 |
| 10 | 1 | 0.018 |
| 11 | 1 | 0.15 |

In Table 1 the molar proportions are shown which allow the preparation of a membrane wherein the guest elements, that is the side chains containing a sterically differing group, exhibit the desired hexagonal distribution pattern.

The values given in Table 1 are confirmed by fluorescence measurements carried out on a film containing as the guest compound 1-palmitoyl-2-[10-(pyren-1-yl)]-decanoyl-sn-glycero-3-phosphocholine (PPDPC) in a dipalmitoylphophatidylcholine matrix (DPPC) on a quartz substrate. This has been illustrated in Example 1.

A symmetrically arranged membrane film has several advantageous properties. Firstly this structure is stable, apparently because only certain modes of vibrations of the film are possible. This means that the excited state of, for example, a pyrene group used as the sterically differing group is more stable than in a film with random distribution, and it cannot dispose of its energy, for example through excimer formation with a vicinal pyrene molecule as quickly as in a film of random distribution. This stability may be further improved by polymerizing the film for example by forming crosslinks between neighbouring side chains.

As an organized film is more stable i.a. with regard to emitting energy absorbed, such a film may be used in applications wherein the stability of such a locally excited state is of advantage, for example as a computer memory element.

Electric measurements made in a direction parallel to the normal of the film surface show that the conductivity of the LB-film changes so that its resistivity decreases considerably when the voltage over the film exceeds a treshold voltage characteristic for the compound used in the film. The low resistivity state is preserved when the voltage is further increased, and the state is also preserved when the voltage is decreased to zero and when the voltage is increased again. If, however, the direction of the voltage over the film is reversed, the reverse phenomenon occurs: the resistivity increases suddenly at a certain treshold voltage and the state is stable until the polarity of the voltage is reversed. The film thus acts as a memory element: writing in the memory corresponds to increasing the voltage over the threshold value, reading the use of a voltage of the same polarity but lower and the simultaneous reading of the resistance. Setting to zero of the memory corresponds to applying across the film a sufficiently high voltage of opposite polarity to that of writing.

By using one or several monomolecular film layers made as defined above on top of a conducting substrate forming an electrode, and by placing another electrode, e.g. a Hg-drop on top of the film layer(s), an effective memory element is obtained, in which the change of state is very prononunced. The different states are also clearly distinguishable from each other as the current at the change of state of the memory becomes $10^2$ -$10^4$ -fold. This is illustrated in Example 2 below.

When making film aggregates using several films one on top of the other, the films may be the same or different. In the last mentioned case it is conceivable to use for example three different types of films, the first one being according to Fig. 2a, the second and the third corresponding to Fig. 2a, but instead of having a repeating unit containing six host elements, structures are used having seven and eight host elements, respectively. By placing these three films on top of each other a film aggregate is obtained wherein three guest groups are located on top of each other at every 7 x 9 x 13 = 819th side chain, which distance corresponds to about 4000 Å. Thus a structure is obtained wherein strongly excited locations are evenly spaced at a distance of approximately 4000 Å. One such a strongly excitable location may function e.g. as a memory cell.

The surface pressures used when making the film according to LB-film-forming techniques are generally not critical but are determined rather by the compression isotherm which is an indicator of the film forming properties of the organic compound used. Usually surface pressures in the range of 10 to 60 mN/m, preferably 20 to 55 mN/m are used.

The following examples illustrate the invention.

Example 1

In order to make the films the lipids (PPDPC and DPPC) were dissolved at a concentration of 0.5 µmoles/litre of chloroform and mixed using predetermined molar proportions in this solvent. The lipid-monolayers were made on purified water and then transferred to quartz glass slides (37.5 x 12.5 mm) using a Langmuir-Blodgett deposition system (apparatus KSV 2200 AFC/DFC) measuring the surface pressure with a platinum Wilhelmy plate. The substrate was first immersed in the subphase onto the surface of which the monomolecular lipid layer was spread. The surface pressure of the lipid layer was adjusted to 40 mN/m, whereafter the substrate was lifted up through the film at a speed of 4 mm/min. During the film deposition the surface pressure was kept constant with an accuracy of 30 µN/m. The transfer ratio was 1.00 ± 0.02. The deposition was carried out at room temperature.

The fluorescence measurements were carried out with a SLM 4800 S-apparatus coupled to a Hewlett Packard 85 computer.

The ratio of the excimer fluorescence intensity (470 nm) to the intensity of monomer fluorescence (376 nm) ($I_E/I_M$) was calculated using the computer. The excitation wave length was 345 nm. The background fluorescence was measured from a non-coated quartz glass substrate and subtracted from the intensity of a substrate coated with a small amount ($x_{PPDPC} < 0.05$) PPDPC exhibing low emission. The excitation spectra were measured separately for both excimer fluorescence at 470 nm and monomer fluorescence at 377 nm.

The fluorescence curve ($I_E/I_M$ vs $x_{PPDPC}$) obtained is shown in Figure 3. It is seen that the curve is not smooth but that at specific values for $x_{PPDPC}$ there are stepwise increments. The smaller schematic figure inserted into Figure 3 further shows that excimer formation appears only at values $x_{PPDPC} > 0.005$.

The stepwise increments in the fluorescence curve supports the symmetrical distribution of PPDCP in a DPPC-matrix at the molar fractions of PPDPC corresponding to the steps in the curve. The most pronounced steps correspond to a distribution pattern, wherein $a_o = b_o$ where the steric elastic strain of vicinal side chains is at a minimum. The fluorescence measurements corresponding to the case $a_o \neq b_o$

also give rise to steps in the curve, although denser measuring points have to be used in order to observe these.

In the Table 2 the critical values $x_{PPDPC}$ from Figure 3 and corresponding values obtained by calculation are shown. The calculated and experimentally determined values correlate well.

Table 2

| $I_E/I_M$ | $x_{PPDPC}$ | | $a_o/b_o$ |
|---|---|---|---|
| | Observed | Calculated | |
| 10.4 | 0.66 | 0.667 | 1/1 |
| 2.20 | 0.268 | 0.2857 | 2/1 |
| 1.40 | 0.165 | 0.1667 | 2/2 |
| 0.94 | 0.074 | 0.0741 | 3/3 |
| 0.46 | 0.038 | 0.0417 | 4/4 |
| 0.45 | - | 0.0267 | 5/5 |
| 0.40 | - | 0.0185 | 6/6 |
| ..... | | | |
| 0.00 | 0.005 | 0.0055 | 11/11 |

Example 2

As film-forming agent a mixture was used containing 66.7% PPDPC and 33.3 % DPPC, i.e. the molar proportion of PPDPC being 0.667, using purified water as the subphase. The mixture was dissolved in chloroform at an amount of 2 mg/ml.

For the LB-film formation as the substrate single crystal p-doped silicon was used which simultaneously acted as one of the electrodes, the other electrode being a Hg-drop.

The films were deposited using a KSV-2200-type apparatus and the deposition was started 20 to 30 minutes after the formation of the monolayer, by moving the substrate upwards through the layer at a speed of 5 mm/min. For each subsequent LB-film a fresh monolayer was spread, prior to which, however, the substrate was introduced into the subphase through the clean water surface: all films were thus coated onto the substrate in the same direction when the substrate was lifted up through the monolayer. In this case three layers were deposited. During film formation the surface pressure was kept constant at 35 mN/m by means of a computer controlled surface pressure monitoring device which was connected back to the motion of the boom compressing the film. After coating the coated substrate was dried in a vacuum desiccator. The current was measured in a box wherein laminar flow was maintained in order to create dustfree conditions. For the current measurements a Keithley 614 electrometer was used at room temperature. The contact area of the Hg-drop was approximately 1 $mm^2$.

In the Figures 4 and 5 the results obtained are shown. The Figure 4 shows the I-U-curves corresponding both to writing and reading the memory, the steepness and amplitude of the change of state being clearly observed, as well as the stability of the state during reading (slight decrease with respect to the "writing"-current). Figure 5 shows the curve for setting the memory to zero (decrease of current when the negative voltage increases) and for rewriting (positive voltage), which also shows the reproducibility of the operation of the memory element.

## Claims

1. A method for the preparation of a monomolecular film exhibiting a symmetrical molecular structure, i.e. a symmetrical distribution pattern of the molecules, wherein a mixture is used comprising
a) a compound (I) of liquid crystal type having a hydrophilic part and a lipophilic part, the lipophilic part comprising two or three substantially aliphatic long-chained hydrocarbon groups, and
b) a compound (II) of liquid crystal type, which is of the same type as that defined under a), but wherein one of the hydrocarbon chains contains covalently bound a group which sterically differs from the hydrocarbon chain,
whereby the molar fraction (x) of the compound (II) in the mixture of compounds (I) and (II) used for the preparation of the film is

$$x = \frac{2}{P - f + 2}$$

wherein f refers to the number of side chains in the compound (II) and $P = a_o^2 + a_o b_o + b_o^2$, wherein $a_o$ and $b_o$ are either zero or positive integers and $a_o + b_o \neq$ zero, and indicate the coordinates of a sterically differing group in 60° coordinate system having its main directions in the film plane and its origo located at a side chain containing a sterically differing group.

2. A method according to Claim 1, wherein,
as the compound (I) and (II), a compound of liquid crystal type containing two substantially aliphatic long-chained hydrocarbon groups is used.

3. A method according to Claim 1, wherein,
as the sterically differing group, a photochromatic group is used.

4. A method according to Claim 1, wherein,
as the sterically differing, group, a pyrene group is used.

5. A method according to Claim 2, wherein,
as the compound (I) dipalmitoylphosphatidylcholine (DPPC), and as the compound (II) 1-palmitoyl-2-[10-(pyren-1-yl)]-decanoyl-sn-glycero-3-phosphocholine are used.

6. Use of a film prepared according to any preceding claim as a computer memory element.

7. A computer memory element including a monomolecular film according to any one of Claims 1 to 5.

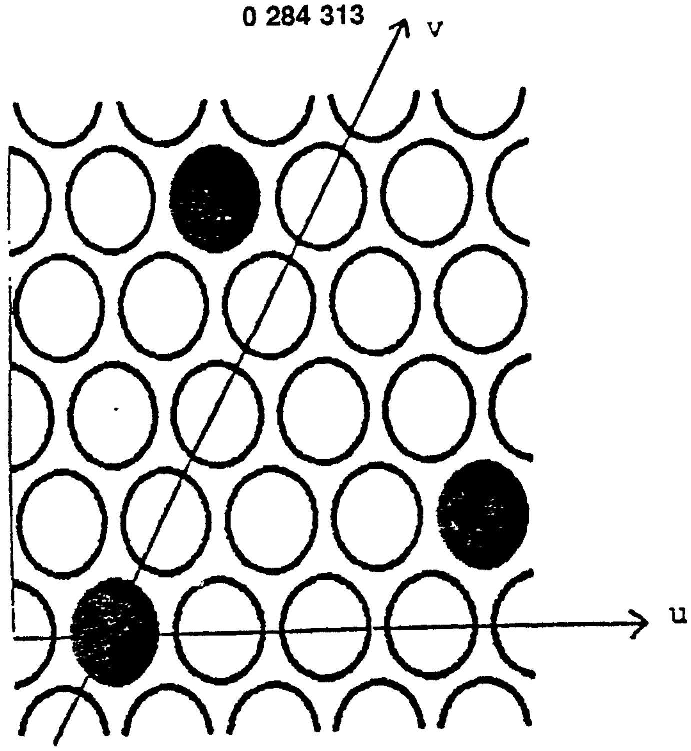


FIG. 1

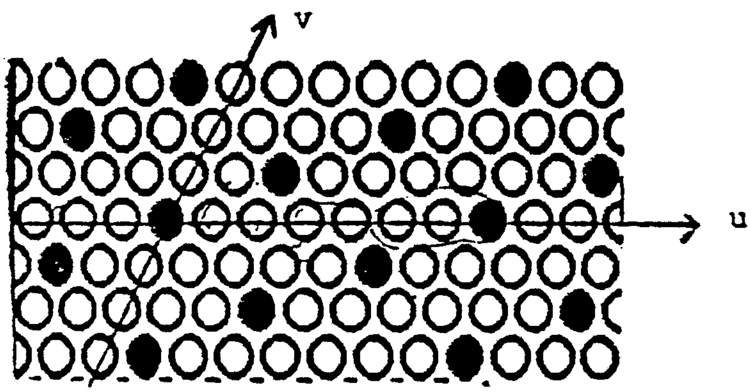


FIG. 2a

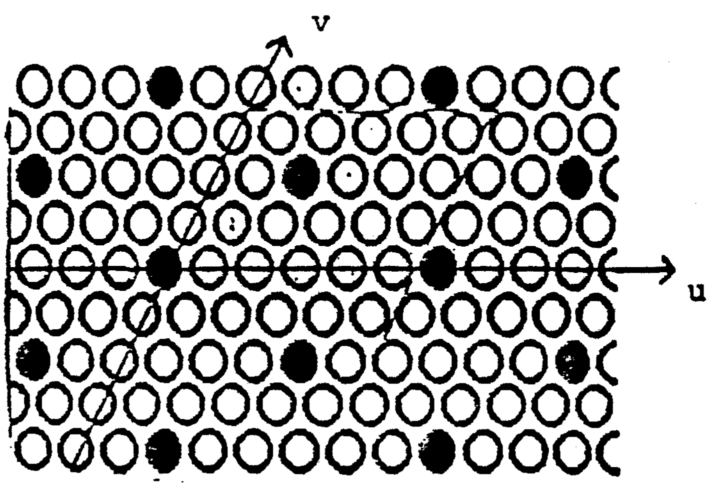


FIG. 2b

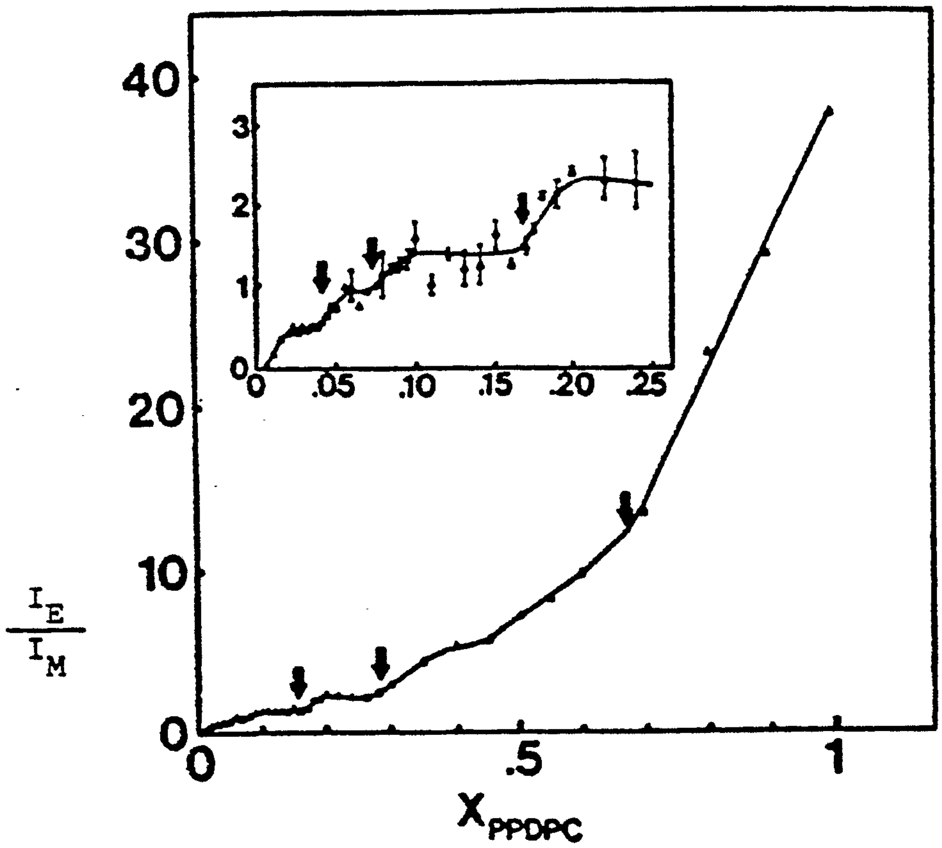


FIG. 3

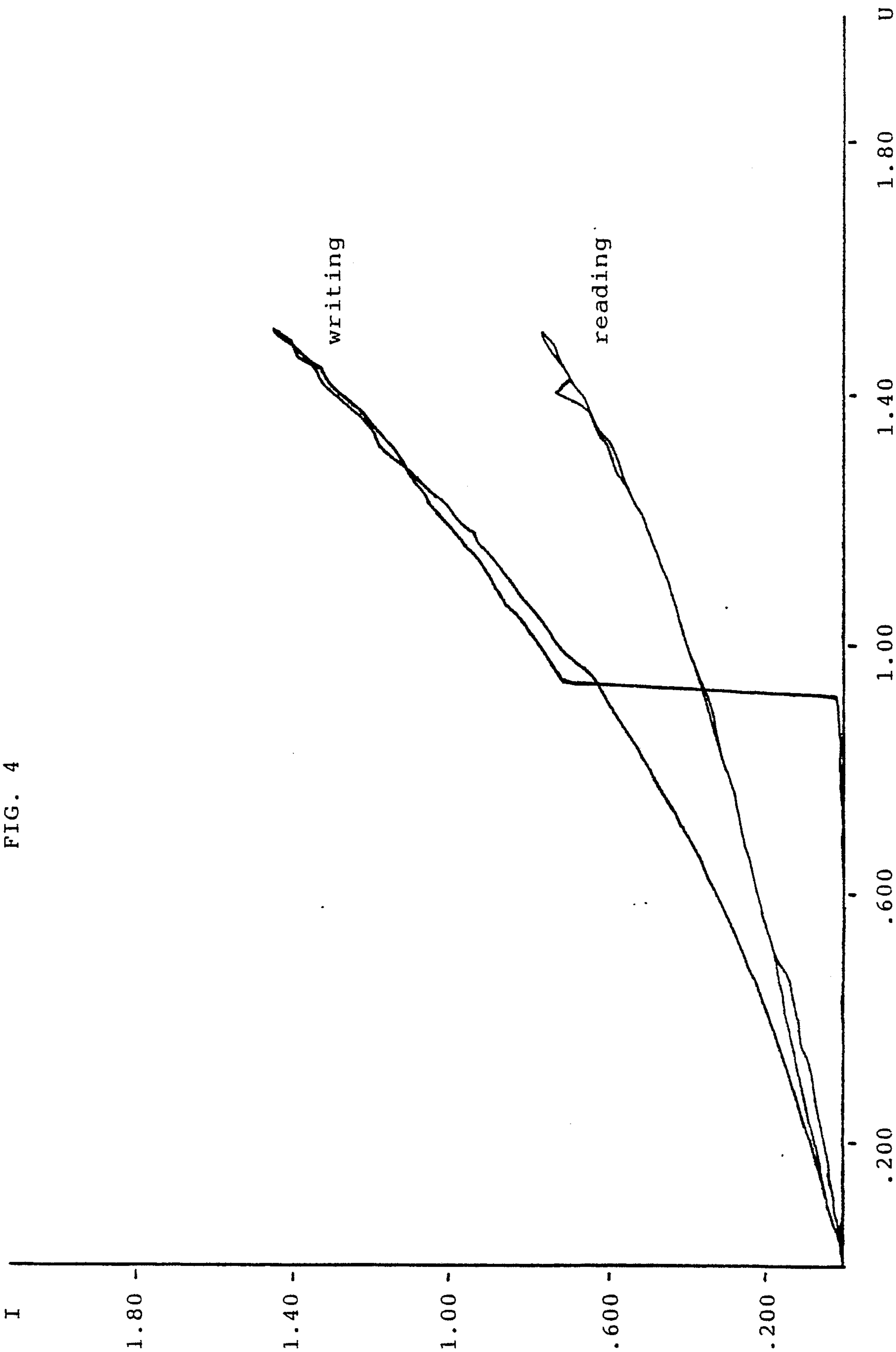


FIG. 4

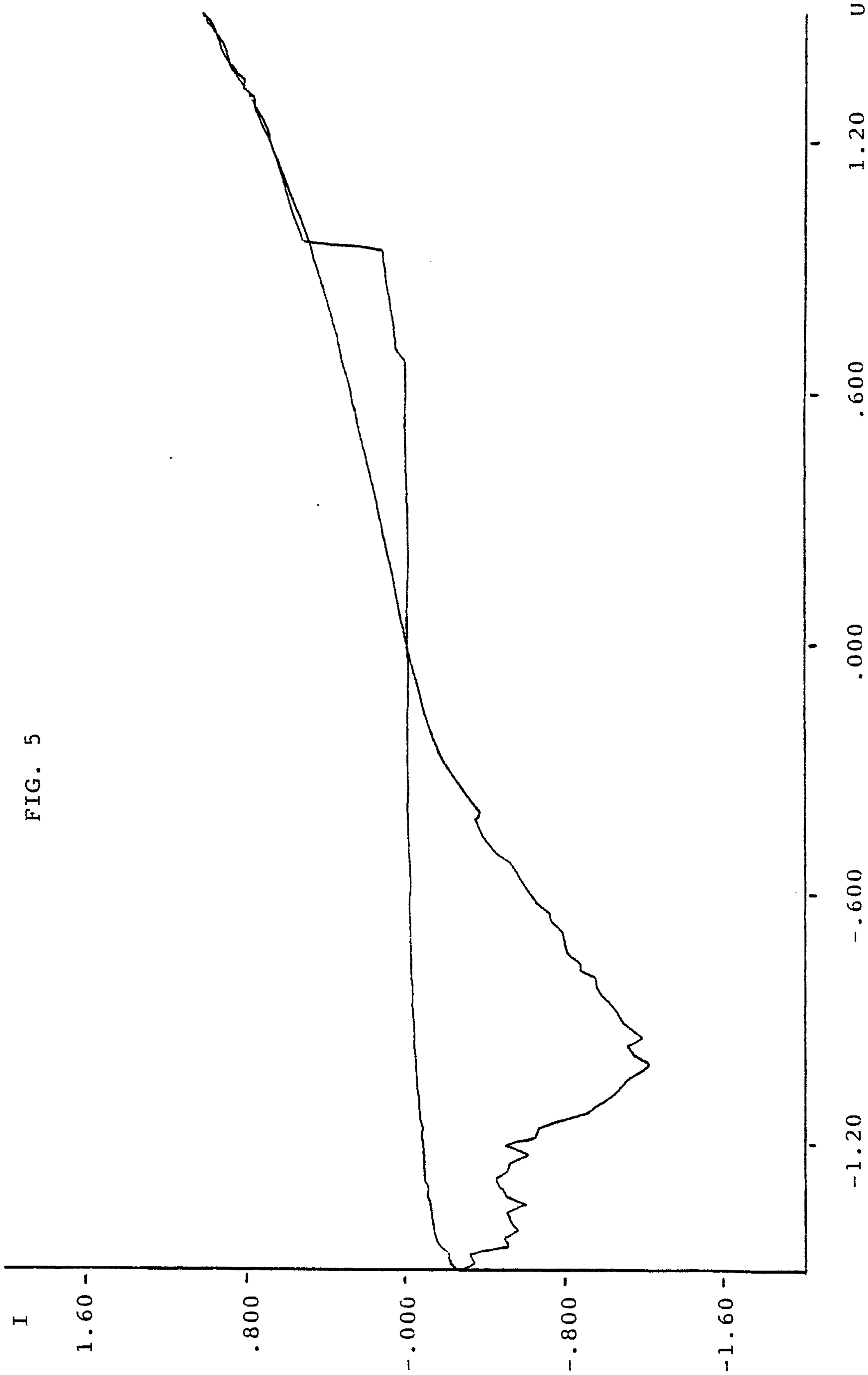


FIG. 5

European Patent Office

# EUROPEAN SEARCH REPORT

Application number

EP 88 30 2423.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 203 780 (THE GENERAL ELECTRIC CO)<br>--- | 1-6 | B 05 D 1/36<br>H 01 L 29/28<br>H 01 L 49/02<br>C 08 J 5/12 |
| A | EP-A-0 208 258 (COMPAGNIE GENERAL D'ELECTRIQUE)<br>--- | 1-6 | |
| A | EP-A-0 184 193 (KANEGAFUCHI KAGAKU KOGYO KABLISHIKI KAISHA)<br>*example 2*<br>--- | 1-6 | |
| A | WO-A-87/00347 (THE SECRETARY OF STATE DEFENCE IN HER BRITANNIC MAYESTY'S GOVERNEMENT OF THE UNITED KINGDOM AND NORTHEN IRELAND)<br>--- | 1-6 | **TECHNICAL FIELDS SEARCHED (Int. Cl.4)** |
| A | US-A-4 632 800 (A BARRAUD ET AL)<br>--- | 1-6 | B 05 D<br>C 08 J<br>C 09 K<br>C 23 C<br>H 01 B<br>H 01 L |
| A | CHEMICAL ABSTRACTS, vol. 85, 1976, Abstract Number 47183g, Y SHIMEZU ET AL; "Studies on binary mixed monolayers containing a vinyl polymer with long side chains as one component" (Fac.Sci.Eng,1976, 25(4), p 212-18)<br>----- | | |

The present search report has been drawn up for all claims

| Place of search | Date of completion of the search | Examiner |
|---|---|---|
| STOCKHOLM | 20-06-1988 | FORSLUND N. |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document